# EUROPÄISCHE PATENTSCHRIFT

(11) **EP 0 650 094 B1**
(45) Veröffentlichungstag und Bekanntmachung des Hinweises auf die Patenterteilung: **02.02.2000**
(21) Anmeldenummer: 94116478.2
(22) Anmeldetag: 19.10.1994
(51) Int. Cl.: G03F 7/34, B41N 3/03

(54) **Lichtempfindliches Material und Verfahren zur Herstellung von Flachdruckplatten**
Photosensitive material and process for making printing plates
Matériau photosensible et procédé pour faire des plaques d'impression

(30) Priorität: 22.10.1993 DE 4336115
(43) Veröffentlichungstag der Anmeldung: 26.04.1995
(73) Patentinhaber: Agfa-Gevaert AG, 51373 Leverkusen (DE)
(72) Erfinder: Gries, Willi-Kurt, Dr., D-65183 Wiesbaden (DE)

(56) Entgegenhaltungen:
- DE-A- 2 631 072
- DE-A- 2 725 762
- FR-A- 1 561 578
- FR-A- 2 080 616
- FR-A- 2 390 295
- US-A- 2 230 981
- US-A- 3 055 295
- US-A- 3 128 181
- US-A- 3 469 983

## Beschreibung

Die Erfindung betrifft ein lichtempfindliches Material, das für die Herstellung von Flachdruckplatten geeignet ist und als wesentliche Bestandteile
a) einen für Flachdruckplatten geeigneten Schichtträger,
b) eine hydrophile Schicht aus einem organischen Polymeren,
c) eine photopolymerisierbare Schicht und
d) eine transparente Deckfolie
enthält.

Sie betrifft ferner ein Verfahren zur Herstellung von Flachdruckplatten, bei dem ein Material der vorstehend angegebenen Gattung bildmäßig belichtet und durch mechanisches Auseinanderziehen ("peel-apart"-Technik) der transparenten Deckfolie und des Schichtträgers entwickelt wird. Materialien und Verfahren dieser Art haben den wesentlichen Vorteil, daß sie zu ihrer Verarbeitung keine Entwicklerlösungen erfordern, die umweltneutral entsorgt werden müssen. Bei der Belichtung ändert sich die Haftung der photopolymerisierbaren Schicht gegenüber den an sie angrenzenden Schichten, so daß beim Auseinanderziehen von Deckfolie und Schichtträger die belichteten Schichtbereiche an der einen Seite und die unbelichteten an der anderen Seite haften.

In der DE-C 15 72 122 ist ein Verfahren zur Herstellung von Bildern beschrieben, bei dem ein Material aus einer transparenten Folie, einer photopolymerisierbaren Schicht und einer zweiten Folie bildmäßig belichtet und durch Auseinanderziehen der Folie zu einem Negativ- und einem Positivbild entwickelt wird.

In der EP-A 514 186 und der US-A 4 895 787 sind ähnliche photopolymerisierbare, durch peel-apart-Entwicklung zu verarbeitende Materialien beschrieben, die zur Herstellung von Farbprüffolien dienen.

In den genannten Druckschriften werden Materialien beschrieben, bei denen eine farblose oder farbige photopolymerisierbare Schicht zwischen zwei dem jeweiligen Verwendungszweck angepaßten Folien angeordnet ist. Zwischen lichtempfindlicher Schicht und Träger- oder Deckfolien können nach Bedarf Haft-, Trenn- oder Farbschichten vorgesehen sein. In jedem Fall wird durch die Belichtung eine Änderung der Haftung gegenüber der Träger- oder Deckfolie bzw. der dazwischenliegenden Schicht und der Kohäsion innerhalb der lichtempfindlichen Schicht bewirkt, so daß durch Ausnutzung der Haftungs- bzw. Kohäsionsdifferenzen beim Auseinanderziehen der Folien eine bildmäßige Trennung innerhalb der lichtempfindlichen Schicht erfolgt. Eine saubere Trennung der belichteten bzw. unbelichteten Schichtbereiche von der jeweils weniger haftenden Folie wird dadurch ermöglicht, daß die Folien relativ glatte Oberflächen haben.

Problematischer ist die Herstellung von Flachdruckplatten nach diesem Verfahren, da die Nichtbildstellen von der Oberfläche des Druckplattenträgers abgelöst werden müssen, der gewöhnlich eine aufgerauhte und ggf. anodisierte Aluminiumplatte ist. Hier würden schon geringste Reste der oleophilen lichtempfindlichen Schicht, die in der rauhen porösen Trägeroberfläche zurückbleiben, die Verwendbarkeit stören, da sie zum Tonen in den Nichtbildstellen führen. Der Ersatz des Trägers durch ein Material mit glatter Oberfläche ist nicht ohne weiteres möglich, da für die Wasserführung beim Flachdruck die strukturierte hydrophile Oberfläche des Trägers erforderlich ist.

In der DE-A 27 25 762 werden lichtempfindliche Druckplatten beschrieben, die durch peel-apart-Entwicklung verarbeitet werden. Die Materialien weisen zwischen dem Druckplattenträger und der lichtempfindlichen photopolymerisierbaren Schicht eine hydrophile Zwischenschicht auf, die z. B. aus einem wasserlöslichen Silikat besteht. Hierdurch wird eine Verbesserung der Schichttrennung bei der Entwicklung erreicht, also eine gute Differenzierung zwischen oleophilen und hydrophilen Bereichen auf der Oberfläche der Druckplatte. Die starke Hydrophilie der Zwischenschicht macht diese aber angreifbar durch wäßrige Lösungen, so daß im Verlauf des Druckvorgangs die Bildelemente der oleophilen Bildschicht unterwaschen und angegriffen werden oder sich sogar ganz vom Träger lösen können. Es lassen sich deshalb keine befriedigenden Druckauflagen erreichen.

In der DE-A 29 23 980 wird eine ähnliche Druckplatte beschrieben, die eine lichtempfindliche Zwischenschicht auf Basis von Diazoverbindungen und darüber eine photopolymerisierbare Schicht aufweist. Diese Platte erlaubt eine bessere Verankerung und Resistenz der Bildstellen, es besteht jedoch wiederum die Gefahr der unvollständigen Entfernung der Diazoschicht, insbesondere nach längerer Lagerung der druckfertigen Druckplatten, so daß auch hier wieder das Problem des Tonens auftritt.

In der EP-A 530 674 wird ein ähnliches Material beschrieben, das zwischen dem Druckplattenträger und der photopolymerisierbaren Bildschicht eine Zwischenschicht aus einem hydrophilen Polymeren, z. B. Polyvinylalkohol, und einer polymerisierbaren Verbindung enthält. Bei der Belichtung nimmt die polymerisierbare Verbindung an der Polymerisation der photopolymerisierbaren Schicht teil und sorgt für eine erhöhte Haftung zwischen diesen Schichten. Auch hier bietet offenbar die Polymerisation in der Zwischenschicht keine ausreichende Resistenz gegen das Auswaschen beim Druckvorgang, so daß keine befriedigenden Druckauflagen erreicht werden.

In der WO-A 93/5446 wird ein Material beschrieben, das dem vorstehend beschriebenen ähnlich ist, aber eine hydrophile photopolymerisierbare Zwischenschicht mit einem relativ hohen Anteil an Monomeren und an Photoinitiator enthält. Hier unterliegt wiederum die Zwischenschicht der Gefahr einer ungewollten teilweisen Polymerisation, wenn sie bei der Verarbeitung nach der Bildbelichtung am Tageslicht gehandhabt wird. Hierbei kann ohne besondere Vorsichtsmaßnahmen leicht eine Polymerisation und damit Oleophilierung in den Nichtbildstellen eintreten, die zum Tonen führt. Diese Schicht wird deshalb vor dem Drucken bevorzugt mit Wasser oder Feuchtwasser ausgewaschen.

Das in der DE-A 26 31 072 offenbarte lichtempfindliches Aufzeichnungsmaterial umfaßt einen hydrophilen Träger, eine Schicht aus einem hydrophilen organischen Polymer, eine lichtempfindliche Schicht und einen transparenten Deckfilm. Nach dem bildmäßigen Belichten wird das Material durch einfaches Abziehen der Deckfolie entwickelt. Je nach Stärke der Haftungskräfte bleiben dabei die belichteten bzw. den unbelichteten Bereiche der lichtempfindlichen Schicht an der Deckfolie haften und werden mitentfernt.

Aufgabe der Erfindung war es, ein wahlweise negativ oder positiv arbeitendes lichtempfindliches Material für die Herstellung von Flachdruckplatten vorzuschlagen, das sich ohne Anwendung von flüssigen Entwicklern zu einer Flachdruckplatte mit hoher Druckleistung und geringer Neigung zum Tonen verarbeiten läßt.

Die Erfindung geht aus von einem lichtempfindlichen Material für die Herstellung von Flachdruckplatten, das als wesentliche Bestandteile
a) einen für Flachdruckplatten geeigneten Schichtträger,
b) eine hydrophile Schicht aus einem organischen Polymeren,
c) eine photopolymerisierbare Schicht und
d) eine transparente Deckfolie
enthält, wobei die Haftung der photopolymerisierbaren Schicht (c) an der hydrophilen Schicht (b) und/oder der Deckfolie (d) durch Belichten verändert wird, dadurch gekennzeichnet, daß die hydrophile Schicht (b) ein organisches Polymeres enthält, das durch darin enthaltene funktionelle Gruppen selbstvernetzend ist, oder daß sie zusätzlich einen Vernetzer für das organische Polymere enthält, oder eine durch Vernetzung eines derartigen Polymeren entstandene Schicht ist.

Das zur Erzeugung der hydrophilen Schicht (b) eingesetzte vernetzbare hydrophile Polymere ist gewöhnlich wasserlöslich. Geeignete Polymere sind von C.L. McCormick, J.Bock und D.N.Schulz in Encyclopedia of Polymer Science and Engineering 17, 730 (1985) beschrieben. Je nach den in den Polymeren enthaltenen funktionellen Gruppen kann die Vernetzung bereits allein mit diesen Polymeren, z. B. durch Erwärmen, erreicht werden. Häufig ist es vorteilhaft, nieder- oder hochmolekulare organische oder anorganische Vernetzer einzusetzen. Auch können zur Beschleunigung der Reaktion Vernetzungskatalysatoren zugesetzt werden.

Beispiele für geeignete wasserlösliche vernetzbare Polymere sind Nucleotide,Polypeptide, Polysaccharide, Polyacrylamide, Polyethylenoxide, Polyvinylalkohole, deren Copolymere oder Pfropf-Copolymere sowie die durch polymeranaloge Umsetzung erhaltenen wasserlöslichen Derivate solcher Polymerer. Auch ionogene Polymere, wie Polyamine, Polyimine, Polyvinylpyridine, Polyvinylpyrrolidone, Poly(meth)acrylsäuren, Polysulfon- und Polyphosphonsäuren, können eingesetzt werden. Ferner können die in den DE-A 40 23 269 und 40 23 268 beschriebenen amphoteren Acrylat-Copolymeren mit Vorteil verwendet werden. Bevorzugte Polymere sind solche mit Vinylalkohol-, Vinylpyrrolidon- und (Meth)acrylsäureeinheiten.

Geeignete Vernetzer sind wasserlösliche mehrwertige Verbindungen, die erst bei erhöhter Temperatur mit dem Polymeren reagieren, z. B. mehrwertige Alkohole wie Glykole oder Oligoglykole, Glycerin, Trimethylolethan oder -propan, Pentaerythrit, mehrwertige Aldehyde wie Glyoxal oder Glutaraldehyd; mehrwertige Säuren wie Oxalsäure, Citronensäure; Oxosäurederivate des Bors, Aluminiums, Siliciums, Phosphors oder Chroms; oder mehrwertige Amine wie Ethylendiamin, Oligoethylenoligoamine oder Polyethylenimine.

Als Vernetzungskatalysatoren sind hauptsächlich Säuren oder Basen, z. B. p-Toluolsulfonsäure, Schwefelsäure, Natronlauge, tertiäre Amine oder quaternäre Ammoniumbasen geeignet. Die Schicht kann ferner Netzmittel, Verlaufmittel, Füllstoffe, Farbstoffe und UV-Absorber enthalten. Das Schichtgewicht der hydrophilen vernetzten bzw. vernetzbaren Schicht liegt im Bereich von 0,001 bis 1, bevorzugt zwischen 0,01 und 0,5 und insbesondere von 0,05 bis 0,3 g/m². Der Mengenanteil an Vernetzer liegt im allgemeinen im Bereich von 0 bis 80, vorteilhaft zwischen 0 und 50, insbesondere bei 1 bis 30 Gew.-%, bezogen auf die Menge des vernetzbaren Polymeren.

Viele vernetzbare Polymere oder Gemische derselben mit Vernetzungsmitteln gehen bereits unter den Bedingungen der Trocknung, also bei Temperaturen im Bereich von 60 - 120 °C und im Verlauf von etwa 1 - 10 Minuten, eine Vernetzungsreaktion ein. Andere Polymere, z. B. Poly(meth)acrylsäuren, bleiben unter den Bedingungen der Trockung im wesentlichen unvernetzt. Sie werden dann im Rahmen einer thermischen Nachbehandlung der Druckplatte, z. B. durch Einbrennen bei etwa 180 - 240 °C im Lauf von 1 bis 25, bevorzugt von 5 bis 20 Minuten, vernetzt und damit unlöslich. Eine Vernetzung der Schicht ist in aller Regel erwünscht und sogar erforderlich, um eine gute Auflagenfestigkeit im Flachdruck, d. h. eine gute Resistenz gegenüber Feuchtwasser, zu erreichen. Die Löslichkeit der unvernetzten hydrophilen Schicht in Wasser oder stark polaren Lösemitteln stört im allgemeinen nicht beim nachfolgenden Aufbringen der photopolymerisierbaren Schicht, da diese aus organischen Lösemitteln aufgebracht wird, die die hydrophile Schicht nicht anlösen.

Die photopolymerisierbare Schicht (c) enthält in an sich bekannter Weise als wesentliche Bestandteile
(1) ein polymeres Bindemittel,
(2) eine radikalisch polymerisierbare Verbindung und
(3) eine Verbindung oder eine Verbindungskombination, die unter der Einwirkung von aktinischer Strahlung die Polymerisation der Verbindung (2) einzuleiten vermag.

Das Bindemittel (1) muß mit den übrigen Bestandteilen kompatibel sein, d. h., über den gesamten Temperaturbereich von Herstellung und Anwendung darf keine Phasentrennung innerhalb der Schicht auftreten. Weiterhin ist es erforderlich, daß je nach Ausführungsform (Positiv- oder Negativ-Typ) entweder die unbelichteten oder die belichteten Schichtstellen eine größere Haftung zur Deckfolie (d) als zum Schichträger (a) aufweisen. Umgekehrt sollten die belichteten bzw. unbelichteten Bereiche stärker am Schichtträger (a) als an der Deckfolie (d) haften. Eine hohe Affinität zur Druckfarbe sowie chemische und mechanische Stabilität innerhalb des Druckprozesses werden ebenfalls durch das Bindemittel mitbestimmt. Beispiele geeigneter Polymerer sind chlorierte Polyolefine, z. B. chlorierte Polyethylene, chlorierte Polypropylene; Poly(meth)acrylsäureester, Polyacrylnitril, Polystyrol, Polyvinylchlorid, Polyvinylidenchlorid, Polybutadien, Polyisopren, Polychloropren, chlorierte Naturkautschuke, Polyvinylacetate, Polyvinylacetale, Polyester, Polyamide und Polyurethane sowie die Copolymeren der diesen Polymeren zugrundeliegenden Monomeren. Bevorzugt verwendet werden chlorierte Naturkautschuke, Poly(meth)acrylate und deren Copolymere sowie Polyamide. Ebenfalls bevorzugt eingesetzt werden Vertreter aus der Klasse der Polyvinylacetale, besonderes der Polyvinylbutyrale. Der Bindemittelanteil in der Photopolymerschicht bewegt sich zwischen 10 und 90, besser jedoch zwischen 70 und 20 %, jeweils bezogen auf das Gewicht der nichfflüchtigen Bestandteile.

Bei der radikalisch polymerisierbaren Verbindung (2) handelt es sich um eine ethylenisch ungesättigte Substanz oder ein entsprechendes Substanzgemisch in Form von Estern bzw. Amiden der Acryl-, Methacryl-, Fumar- oder Maleinsäure. Bevorzugt sind Vertreter mit mehr als einer polymerisierbaren Doppelbindung, z.B. die Ester der genannten Säuren mit Alkandiolen, (Poly/Oligo)ethylenglykolen, (Poly/Oligo)propylenglykolen, (Poly/Oligo)butylenglykolen und anderen bifunktionellen nieder- oder hochmolekularen organischen Diolen. Besonders geeignet sind die Ester von mehrwertigen Alkoholen, wie Glycerin, Trimethylolethan bzw. -propan, Pentaerythrit, Isocyanursäure, deren ethoxylierten oder propoxylierten Derivaten, sowie Dimere oder Oligomere dieser Verbindungen. Ein möglichst hoher Veresterungsgrad ist dabei vorteilhaft. Ebenfalls verwendbar sind Amide, z. B. die Verbindungen, die formal bei der Umsetzung von Ethylendiamin oder dessen Oligomeren mit den beschriebenen Säuren entstehen. Der Mengenanteil der Monomeren liegt bei etwa 5 bis 80, bevorzugt bei etwa 10 bis 60 Gew.-% der nichtflüchtigen Bestandteile.

Als Photoinitiatoren (3) kommen je nach gewünschtem Sensibilisierungsbereich unterschiedliche Materialien zum Einsatz. Soll das lichtempfindliche Material für den im Offsetdruck üblichen nahen UV-Bereich (350 - 420 nm) empfindlich sein, so werden andere Photoinitiator-Systeme verwendet als wenn im sichtbaren Spektralbereich, beispielsweise mit Laserstrahlung, belichtet werden soll.

Die im nahen UV-Bereich zu belichtenden Photoinitiatoren sollen Licht im Bereich zwischen ca. 250 und 500 nm unter Ausbildung von Radikalen absorbieren. Beispiele sind Acyloine und deren Derivate wie Benzoin, Benzoinalkylether, vicinale Diketone und deren Derivate, z. B. Benzil, Benzilacetale wie Benzildimethylketal, Fluorenone, Thioxanthone, Mehrkernchinone, Acridine und Chinoxaline, ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen und Acylphosphinoxid-Verbindungen. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Bei den besonders für Laserbestrahlung im sichtbaren Bereich eingesetzten Photoinitiatoren kommen meist Gemische aus Metallocenen, photoreduzierbaren Farbstoffen, photolytisch spaltbaren Verbindungen mit Trihalogenmethylgruppen und ggf. weiteren Initiator- und Farbstoffbestandteilen in Frage, wie sie z. B. in der EP-A 364 735 beschrieben sind. Die Metallocen-Komponente besteht aus verschiedenartig substituierten Cyclopentadienyl-Komplexen des Titans oder Zirkoniums. Als photoreduzierbare Farbstoffe können Xanthen-, Benzoxanthen-, Benzothioxanthen-, Thiazin-, Pyronin-, Porphyrin- oder Acridin-Farbstoffe verwendet werden. Bei den Trihalogenmethyl-Coinitiatoren haben sich besonders die bekannten Triazin-Derivate mit Brom oder Chlor als Halogen bewährt. Weitere Initiatorbestandteile sind Verbindungen, die die Empfindlichkeit vor allem in nahen UV-Bereich steigern, z. B. Acridin-, Phenazin- oder Chinoxalin-Derivate, oder die eine Empfindlichkeitssteigerung im sichtbaren Bereich bewirken, z. B. Dibenzalacetone oder Cumarine.

Die Menge des Photoinitiators bzw. der Initiator-Kombination beträgt im allgemeinen etwa 0,1 bis 15 Gew.-%, bevorzugt etwa 0,5 bis 10 Gew.-% der nichtflüchtigen Schichtbestandteile.

Die photopolymerisierbare Schicht kann darüber hinaus Stabilisatoren zur Unterdrückung von thermischer Polymerisation, Pigmente, Farbstoffe, Weichmacher oder andere Hilfsstoffe zur Verbesserung von mechanischer oder reprographischer Qualität enthalten. Dabei ist grundsätzlich zu beachten, daß die beigefügten Stoffe keinen übergroßen Anteil des für die Vernetzung notwendigen aktinischen Lichtes absorbieren und dadurch die praktische Lichtempfindlichkeit herabsetzen. In den Fällen, in denen zur Steigerung der Schichtstabilität ein thermischer Nachbehandlungsschritt durchgeführt werden soll, können zusätzliche Komponenten zu deren thermischen Aushärtung, enthalten sein.

Die Schichtdicke der photopolymerisierbaren Schicht (c), ausgedrückt durch das Schichtgewicht, beträgt 0,1 bis 10, vorzugsweise 0,5 bis 5,0 g/m².

Als flexible transparente Deckfolien (d) für das erfindungsgemäße Material sind insbesondere solche Kunststoffolien geeignet, die beim Erwärmen auf etwa 60 bis 130 °C maßbeständig sind. Hierfür kommen z. B. Folien aus Celluloseacetat, Polystyrol, Polyamiden, Polycarbonaten, Polyestern und Polyimiden in Betracht. Die Folie sollte vorzugsweise für Luftsauerstoff wenig durchlässig sein. Deshalb werden vorzugsweise Folien aus Polyestern, Polycarbonaten, Polyimiden und ähnlichen Polymeren eingesetzt; Polyesterfolien werden im allgemeinen bevorzugt. Die Deckfolie kann eine Dicke im Bereich von etwa 10 bis 100, vorzugsweise 12 bis 50 µm aufweisen. Zur Verbesserung der Maßbeständigkeit werden die Folien im allgemeinen biaxial verstreckt und ggf. thermofixiert. Zur Verbesserung der Haftung der photopolymerisierbaren Schicht (c) kann die Oberfläche einer die Haftung erhöhenden Behandlung unterworfen werden, z. B. durch Coronaentladung, durch Ätzen mit Chemikalien, z. B. Trichloressigsäure, und durch Beschichten mit einer haftvermittelnden Unterschicht. Derartige Beschichtungen sind im allgemeinen 0,001 bis 0,1 µm dick. Sie können aus Copolymeren von (Meth)acrylsäureestern bestehen, wie sie z. B. in der US-A 4 098 952 beschrieben sind, und vorzugsweise vernetzt sein. Geeignete Folien sind in der US-A 5 049 476 beschrieben. Die Oberfläche der Folie kann auch einer das Blocken verhindernden Behandlung unterworfen werden, z. B. durch Beschichten mit einer geeigneten Unterschicht, die feinteilige organische oder insbesondere anorganische Partikel enthält, deren Größe, Menge und Brechungsindex so bemessen sind, daß die Transparenz der Folie nicht beeinträchtigt ist. Die Oberfläche kann glatt oder mattiert sein. Entsprechende Folien sind z. B. in der EP-A 130 222 beschrieben.

Der Schichtträger (a) ist eine als Trägermaterial für Flachdruckplatten übliche metallische Platte mit hydrophiler Oberfläche. Als Metall wird Aluminium bevorzugt, das insbesondere oberflächlich aufgerauht und anodisch oxydiert ist. Die Oberfläche kann weiterhin in bekannter Weise mit Alkalisilikaten, Phosphaten, Hexafluorozirkonaten, Polyvinylphosphonsäure oder anderen üblichen Vorbehandlungsmitteln behandelt worden sein. Die Dicke des Schichtträgers liegt im allgemeinen zwischen 0,05 und 1, vorzugsweise zwischen 0,1 und 0,5 mm.

Die Herstellung des lichtempfindlichen Materials erfolgt in der Weise, daß die Bestandteile der hydrophilen Schicht (b) in einem geeigneten Lösemittel, i. a. Wasser oder einem Gemisch von Wasser und damit mischbaren organischen Lösemitteln, wie niederen Alkanolen,. Aceton oder dgl., gelöst und auf die Oberfläche des Schichtträgers (a) in der Weise aufgebracht werden, daß nach dem Trocknen die gewünschte Schichtdicke erhalten wird. Auf die getrocknete Zwischenschicht wird dann die photopolymerisierbare Schicht (c) in der Regel ebenfalls durch Beschichten aus einer Lösung aufgebracht. Das Lösemittel wird dabei so gewählt, daß die hydrophile Zwischenschicht (b) nicht angelöst wird. Auf die photopolymerisierbare Schicht (c) wird dann durch Laminieren die Deckfolie (d) aufgebracht. Das Laminieren kann bei Raumtemperatur oder bei erhöhter Temperatur erfolgen. Es kann auch die photopolymerisierbare Schicht durch Beschichten aus einer Lösung auf die Deckfolie aufgebracht, dort getrocknet und dann durch Laminieren auf den mit der hydrophilen Schicht (b) beschichteten Schichträger (a) aufgebracht werden. Dieser Laminiervorgang kann auch zu einem späteren Zeitpunkt nach Lagerung der Elemente aus (a) + (b) und (c) + (d) durchgeführt werden. In diesem Fall ist es aber zweckmäßig, die freiliegende Seite der photopolymerisierbaren Schicht (c) mit einer abtrennbaren Schutzfolie, z. B. aus Polyethylen, abzudecken, die dann erst unmittelbar vor dem Laminieren abgezogen wird.

Das erhaltene lichtempfindliche Material wird in bekannter Weise durch die transparente Deckfolie (d) hindurch bildmäßig belichtet. Die Belichtung kann durch eine entsprechend gesteuerte Strahlungsquelle, z. B. einen Laser, oder im Kontakt unter einer Transparentvorlage erfolgen. Durch die bildmäßige Vernetzung der photopolymerisierbaren Schicht wird deren Haftung gegenüber der Deckfolie (d) und bzw. oder der hydrophilen Zwischenschicht (b) verändert, so daß beim Abziehen der Deckfolie entweder die belichteten oder die unbelichteten Schichtbereiche mit dieser entfernt werden. Im ersten Fall verbleibt ein positives, im zweiten Fall ein negatives Bild auf dem Schichtträger (a). Die Steuerung des Haftverhaltens, die entweder ein positives oder ein negatives Bild ergibt, läßt sich mit grundsätzlich bekannten Mitteln erreichen. Da allgemein die Haftung der photopolymerisierbaren Schicht gegenüber der rauhen Oberfläche des Schichtträgers (a), die durch die relativ dünne hydrophile Schicht (b) nicht eingeebnet wird, stärker ist als gegenüber der transparenten Deckfolie (d), sollte diese Folie in der Regel eine haftverstärkende Oberflächenbehandlung erfahren, wie es oben beschrieben ist. In den meisten Fallen bewirkt die Photopolymerisation eine Erhöhung der Haftung der Schicht (c) an der rauhen, von der Zwischenschicht (b) bedeckten Oberfläche des Schichtträgers (a). Eine Änderung dieses Verhaltens läßt sich sowohl durch Änderung der Zusammensetzung, insbesondere der Art des Bindemittels und der polymerisierbaren Verbindung, der Schicht (c) und der hydrophilen Schicht (b) erreichen. So wird in vielen Fällen mit hydrophilen Schichten, deren Hydrophilie auf der Anwesenheit von OH-Gruppen beruht, die Haftung an der Grenzflächen von (b) zu (c) durch Belichten derart verändert, daß ein negatives Bild erhalten wird. In anderen Fällen, in denen die Schicht (b) z. B. Carboxylgruppen oder andere Säuregruppen enthält, werden häufig Positive erhalten. Im allgemeinen hat die Natur der photopolymerisierbaren Schicht einen größeren Einfluß auf das Kopierergebnis. So werden mit Schichten, die übliche Radikalinitiatoren und Bindemittel auf Basis von (Meth)acrylatpolymeren enthalten, vorwiegend negative Kopien, dagegen mit Schichten, die Polyvinylacetale als Bindemittel und solche Initiatoren enthalten, die bei Belichtung Säuren bilden, in der Regel positive Kopien erhalten. Möglichkeiten zur Beeinflussung des Haftverhaltens sind bekannt und u. a. in dem Artikel "Photosensitive Materials by Peel-off Development" von T. Ikeda, T. Yamaoka und T. Tsunoda in Graphic Arts Japan, Vol. 21 (1979-1980), Seiten 26 - 31, beschrieben.

Nach der Bildentwicklung kann das auf dem Schichtträger verbliebene Bild zur Erhöhung der Auflagenstabilität beim Druck in an sich bekannter Weise thermisch nachgehärtet bzw. eingebrannt werden. Insbesondere bei Positivdruckplatten, bei denen auf dem Schichtträger die unpolymerisierten Schichtbereiche zurückbleiben, ist es empfehlenswert, die Druckschablone durch Erhitzen und bzw. oder Nachbelichten zu härten.

Durch das erfindungsgemäße Material und Verfahren wird erreicht, daß man Flachdruckplatten durch eine Verarbeitung erhält, zu der keine flüssigen Entwickler oder andere Verarbeitungslösungen erforderlich sind. Gegenüber bekannten Verfahren dieser Art hat das erfindungsgemäße Verfahren den Vorteil, daß es Druckplatten mit einer deutlich höheren Auflagenstabilität liefert.

Die folgenden Beispiele erläutern bevorzugte Ausführungsformen der Erfindung. Mengenverhältnisse und Prozentangaben sind, wenn nichts anderes gesagt wird, als Gewichtseinheiten zu verstehen. Die Mengen werden zumeist in Gewichtsteilen (Gt) angegeben.

### Beispiel 1

a) Eine Lösung der im folgenden angegebenen Zusammensetzung wurde auf eine 50 µm dicke biaxial verstreckte und thermofixierte Polyethylenterephthalatfolie aufgebracht, deren Oberflächen auf beiden Seiten zur Haftverbesserung vorhandelt worden waren (®Melinex 505):
   - 2,36: Gt Polyethylmethacrylat (Tg 65 °C, Säurezahl 8),
   - 0,05: Gt Polymethylmethacrylat (Tg 105 °C, Säurezahl <1),
   - 2,15: Gt Trimethylolpropantriacrylat,
   - 0,08: Gt 2-Benzyl-2-dimethylamino-1-(4-morpholino-phenyl)-butan-1-on,
   - 0,25: Gt Renolblau B2G (C. I. 74 160),
   - 0,09: Gt 4-Diethylamino-4'-methoxy-dibenzalaceton und
   - 0,03: Gt 2,6-Di-tert.-butyl-4-methylphenol in
   - 49,8: Gt Butanon,
   - 2,5: Gt Tetrahydrofuran,
   - 35,6: Gt Propylenglykolmonomethylether und
   - 7,13: Gt γ-Butyrolacton
   Nach dem Trocknen betrug das Schichtgewicht 1,91 g/m².
b) Eine 0,3 mm dicke elektrolytisch aufgerauhte und anodisch oxydierte Aluminiumplatte mit einem Oxidschichtgewicht von 3,6 g/m² wurde mit einer 0,1 %igen wäßrigen Polyvinylphosphonsäurelösung nachbehandelt. Auf diesen Schichtträger wurde eine wäßrige Lösung von 0,9 % eines teilverseiften Polyethylenglykol/Vinylacetat-Pfropfpolymerisats mit der Esterzahl 150, 0,1 % Glyoxal und 0,01 % p-Toluolsulfonsäure aufgeschleudert, so daß sich nach dem Trocknen ein Schichtgewicht von 0,2 g/m² ergab.
c) Das unter (a) beschriebene photopolymerisierbare Material wurde unter Druck bei 90 °C auf den unter (b) beschriebenen Schichtträger laminiert. Die erhaltene lichtempfindliche Druckplatte wurde mit einer 5 kW-Metallhalogenidlampe im Abstand von 110 cm 12 Sekunden im Kontakt unter einer Testvorlage belichtet. Danach wurde die Polyesterfolie von Hand abgezogen, wobei die unbelichteten Schichtbereiche sauber mit der Folie entfernt wurden und die belichteten Schichtbereiche zusammen mit der gehärteten Pfropfpolymerschicht auf der Aluminiumplatte als negative Kopie guter Auflösung zurückblieben. Das Negativbild wurde ohne Vorlage 100 Sekunden nachbelichtet und zur Prüfung der Resistenz gegen Auswaschen jeweils 20 Minuten im Ultraschallbad mit Wasser (1), mit 1%iger wäßriger Polyethylenglykol-(300)-nonylphenylether-Lösung (2) und mit 1 %iger Natrium-Dodecylbenzolsulfonatlösung (3) behandelt. In keinem Falle wurden dabei die Bildstellen angegriffen oder unterwaschen. Auf einer handelsüblichen Offsetdruckmaschine wurden in mehreren Versuchen 25000 bis 30000 Drucke gleichbleibender Qualität erreicht.

### Vergleichsbeispiel 1

Wie in Beispiel 1 wurde eine Aluminiumplatte mit einer 1 %igen Lösung des in Beispiel 1 angegebenen Pfropfpolymerisats in Wasser beschichtet. Nach dem Trocknen betrug das Schichtgewicht 0,1 g/m². Das gemäß Beispiel 1(a) hergestellte photopolymerisierbare Material wurde, wie unter 1(c) beschrieben, auf die beschichtete Aluminiumplatte laminiert, belichtet und durch Abziehen der Polyesterfolie entwickelt. Die erhaltene Druckplatte blieb bei der Ultraschallbehandlung in Wasser stabil, wurde aber in Lösung (2) wenig und in Lösung (3) etwas stärker unterspült, was sich durch Unterwaschen und Ablösen von einzelnen Bildelementen zu erkennen gab. Unter den gleichen Druckbedingungen wie in Beispiel 1 wurden nur 8000 bis 10000 Drucke gleichbleibender Qualität erhalten.

### Beispiel 2

Wie im Beispiel 1 beschrieben, wurde eine Polyesterfolie mit der folgenden Lösung beschichtet:
- 2,910: Gt Polyethylmethacrylat wie in Beispiel 1,
- 0,728: Gt Polyethylmethacrylat (Tg: 63 °C; Säurezahl 0),
- 0,140: Gt Polymethylmethacrylat wie in Beispiel 1,
- 2,457: Gt Pentaerythrittetraacrylat,
- 0,203: Gt Bis-cyclopentadienyl-bis-[2,6-difluor-3-(pyrr-1-yl)-phenyl]-titan,
- 0,035: Gt 2,6-Di-tert.-butyl-4-methylphenol,
- 0,175: Gt Renolblau B2G,
- 0,028: Gt 2-(p-Styryl-phenyl)-4,6-bis-trichlormethyl-s-triazin und
- 0,322: Gt Eosin alkohollöslich (C. I. 45 386) in
- 51,2: Gt Butanon,
- 34,9: Gt Propylenglykolmonomethlyether und
- 6,98: Gt γ-Butyrolacton
Das Schichtgewicht betrug nach dem Trocknen 2,14 g/m2. Die weitere Verarbeitung erfolgte wie im Beispiel 1, jedoch wurde mit einer 500W-Glühlampe 9 s belichtet (Abstand = 110 cm). Nach Abziehen der Polyesterfolie verblieb ein Negativbild, das unter den in Beispiel 1 beschriebenen Bedingungen im Ultraschallbad stabil war und auf einer handelsüblichen Offsetdruckmaschine über 20 000 Drucke gleichbleibender Qualität lieferte.

### Beispiel 3

Wie in Beispiel 1 beschrieben, wurde eine Polyesterfolie mit der folgenden Lösung beschichtet:
- 2,24: Gt Alkylmethacrylat-Copolymeres (Tg 80 °C, Säurezahl 5)
- 17,9: Gt Polyvinylbutyral (80 % Vinylbutyraleinheiten, 18 % Vinylalkoholeinheiten, 2 % Vinylacetateinheiten, Tg 72 - 78 °C),
- 28,0: Gt Pentaerythrittetraacrylat,
- 1,12: Gt 2-(p-Styryl-phenyl)-4,6-bis-trichlormethyl-s-triazin,
- 6,44: Gt Renolblau B2G und
- 0,28: Gt 2,6-Di-tert.-butyl-4-methylphenol in
- 409: Gt Tetrahydrofuran,
- 279: Gt Propylenglykolmonomethylether und
- 55,8: Gt γ-Butyrolacton
Das Schichtgewicht betrug nach dem Trocknen 2,7 g/m².

Die unter 1(b) beschriebene Aluminiumplatte wurde mit einer Lösung von
- 0,5: Gt Trimethylolpropan,
- 1,98: Gt Polyacrylsäure (M = 5800, durch GPC bestimmt),
- 0,03: Gt p-Toluolsulfonsäure und
- 0,1: Gt Nonylphenolpolyethylenglykol-(300)-ether in
- 97,4: Gt Wasser
beschichtet. Nach dem Trocknen wurde ein Schichtgewicht von 0,2 g/m² erhalten. Die weitere Verarbeitung erfolgte wie in Beispiel 1, jedoch wurde 14 Sekunden belichtet. Danach wurde die Polyesterfolie zusammen mit den belichteten Schichtbereichen abgezogen, so daß eine positive Kopie guter Auflösung auf dem Aluminiumträger zurückblieb. Das unter einer Polyethylenfolie im Vakuum ohne Vorlage 50 Sekunden belichtete Material wurde wie im Beispiel 1 im Ultraschallbad auf die Resistenz gegen Unterwaschen geprüft. Die Bildelemente blieben in allen drei Lösungen stabil und ließen keinen Angriff erkennen.

### Vergleichsbeispiel 2

Wie im Beispiel 3 beschrieben, wurde eine Druckplatte hergestellt, wobei aber die als Träger dienende Aluminiumplatte mit einer Lösung von 2 Gt der in Beispiel 3 angegebenen Polyacrylsäure in 98 Gt einer 0,1 %igen wäßrigen Lösung von Nonylphenolpolyglykol-(300)-ether beschichtet wurde. Das Schichtgewicht betrug nach dem Trocknen 0,2 g/m². Bei der Resistenzprüfung waren nach der Behandlung mit Lösung 3 deutliche Bildschäden zu erkennen.

### Beispiel 4

Wie im Beispiel 1 beschrieben, wurde eine Polyesterfolie mit der folgenden Lösung beschichtet:
- 7,00: Gt Alkylmethacrylat-Copolymeres wie in Beispiel 3,
- 56,0: Gt Polyvinylbutyral wie in Beispiel 3,
- 36,0: Gt Pentaerythrittetraacrylat,
- 54,0: Gt Dipentaerythritpentaacrylat,
- 3,60: Gt 2-(p-Styryl-phenyl)-4,6-bis-trichlormethyl-s-triazin,
- 10,8: Gt Terephthalaldehyd,
- 6,50: Gt Renolblau B2G und
- 0,90: Gt 2,6-Di-tert.butyl-4-methylphenol in
- 1001: Gt Tetrahydrofuran,
- 683: Gt Propylenglykolmonomethylether und
- 137: Gt γ-Butyrolacton
Das Schichtgewicht betrug 2,3 g/m².

Die in Beispiel 1b beschriebene Aluminiumplatte wurde mit einer Lösung von 24,0 g einer 40 prozentrigen wäßrigen Lösung eines Acrylharzes (Röhm Acrytex W 240) in 576 g einer 0,1 prozentigen Tensid-Lösung (Decyl-diphenyletherdisulfonsäure-Dinatriumsalz) beschichtet. Das Schichtgewicht nach Trocknen betrug 0,2 g/m². Die analog Beispiel 3 hergestellte Positiv-Druckplatte wurde nach Behandlung mit einer Einbrenngummierung (ca. 5 %ige Lösung eines anionischen Tensids in Wasser) 15 Minuten bei 200 °C eingebrannt, wodurch Unterschicht und Bildschicht vernetzt wurden. Die Druckplatte war nach der in Beispiel 1 beschriebenen Ultraschallbehandlung völlig stabil und zeigte auf einer handelsüblichen Offsetdruckmaschine selbst nach 60000 Drucken noch keinerlei Qualitätsveränderungen.

### Beispiele 5 bis 12

Die in Beispiel 1 angegebene photopolymerisierbare Lösung wurde wie dort beschrieben auf eine Folie aufgebracht und getrocknet. Das Schichtgewicht betrug 2,5 g/m². Wie in Beispiel 1 wurde eine Aluminiumplatte mit einer Lösung von 0,8 Gt des dort angegebenen Pfropfpolymerisats und 0,2 Gt einer der in der folgenden Tabelle I angegebenen Vernetzungskomponenten in 99 Gt Wasser beschichtet und 1 Minute bei 100 °C getrocknet. Das erhaltene Schichtgewicht ist ebenfalls in Tabelle I angegeben.

**Tabelle I**

| **Beispiel** | **Vernetzungskomponente** | **Schichtgewicht (g/m**^{**2**}**)** |
|---|---|---|
| 5 | H₃BO₃ | 0,10 |
| 6 | AlCl₃ x 6 H₂O | n.b. |
| 7 | H₄SiO₄^{*)} | 0,06 |
| 8 | H₃PO₄ | 0,08 |
| 9 | (NH₄)₆Mo₇O₂₄ x 4 H₂O | 0,12 |
| 10 | H₃P(Mo₃O₁₀)₄ x H₂O | 0,10 |
| 11 | Citronensäure/p-Toluolsulfonsäure ^{**)} | 0,11 |
| 12 | Polyacrylsäure/p-Toluolsulfonsäure ^{**)} | 0,08 |

| | | |
|---|---|---|
| ^{*)} in situ hergestellt durch Hydrolyse von Tetraethylorthosilikat | | |
| ^{**)} Menge der p-Toluolsulfonsäure jeweils 0,01 g | | |
| n.b. = nicht bestimmbar | | |

Wie im Beispiel 1 beschrieben wurden Druckplatten hergestellt und verarbeitet. Es wurden Negativkopien guter Qualität erhalten und der Resistenzprüfung unterworfen. Tabelle II zeigt die Ergebnisse.

**Tabelle II**

| **Beispiel** | **Lösung 1** | **Lösung 2** | **Lösung 3** |
|---|---|---|---|
| 5 | ++ | ++ | ++ |
| 6 | ++ | ++ | ++ |
| 7 | ++ | ++ | ++ |
| 8 | + | + | + |
| 9 | + | + | + |
| 10 | + | + | 0 |
| 11 | ++ | ++ | + |
| 12 | ++ | + | + |
| V2 | + + | - | - |

| | | | |
|---|---|---|---|
| -- = Bildelemente stark beschädigt | | | |
| - = Bildelemente deutlich beschädigt | | | |
| 0 = Bildelemente leicht beschädigt | | | |
| + = Bildelemente geringfügig beschädigt | | | |
| + + = Bildelemente nicht beschädigt | | | |

## Patentansprüche

1. Lichtempfindliches Material für die Herstellung von Flachdruckplatten, das als wesentliche Bestandteile
a) einen für Flachdruckplatten geeigneten Schichtträger,
b) eine hydrophile Schicht aus einem organischen Polymeren,
c) eine photopolymerisierbare Schicht und
d) eine transparente Deckfolie
enthält, wobei die Haftung der photopolymerisierbaren Schicht (c) an der hydrophilen Schicht (b) und/oder der Deckfolie (d) durch Belichten verändert wird, dadurch gekennzeichnet, daß die hydrophile Schicht (b) ein organisches Polymeres enthält, das durch darin enthaltene funktionelle Gruppen sebstvernetzend ist, oder daß sie zusätzlich einen Vernetzer für das organische Polymere enthält, oder eine durch Vernetzung eines derartigen Polymeren entstandene Schicht ist.

2. Lichtempfindliches Material nach Anspruch 1, dadurch gekennzeichnet, daß das vernetzbare organische Polymere Hydroxy-, Carboxyl- oder Aminogruppen als vernetzbare Gruppen enthält.

3. Lichtempfindliches Material nach Anspruch 1, dadurch gekennzeichnet, daß der Vernetzer eine wasserlösliche mehrwertige Verbindung ist, die erst bei erhöhter Temperatur mit dem Polymeren reagiert.

4. Lichtempfindliches Material nach Anspruch 1 oder 3, dadurch gekennzeichnet, daß die hydrophile Schicht ferner einen Vernetzungskatalysator enthält.

5. Lichtempfindliches Material nach Anspruch 1, dadurch gekennzeichnet, daß die hydrophile Schicht (b) ein Schichtgewicht im Bereich von 0,001 bis 1 g/m² hat.

6. Lichtempfindliches Material nach Anspruch 1, dadurch gekennzeichnet, daß die photopolymerisierbare Schicht (c) als wesentliche Bestandteile
(1) ein polymeres Bindemittel,
(2) eine radikalisch polymerisierbare Verbindung und
(3) eine Verbindung oder eine Verbindungskombination enthält, die unter Einwirkung von aktinischer Strahlung die Polymerisation der Verbindung (2) einzuleiten vermag.

7. Lichtempfindliches Material nach Anspruch 1, dadurch gekennzeichnet, daß die photopolymerisierbare Schicht (c) ein Schichtgewicht im Bereich von 0,1 bis 10 g/m² hat.

8. Verfahren zur Herstellung einer Flachdruckform, bei dem man ein lichtempfindliches Material, das als wesentliche Bestandteile
a) einen für Flachdruckplatten geeigneten Schichtträger,
b) eine hydrophile Schicht aus einem organischen Polymeren,
c) eine photopolymeriserbare Schicht und
d) eine transparente Deckfolie
enthält, wobei die Haftung der photopolymerisierbaren Schicht (c) an der hydrophilen Schicht (b) und/oder der Deckfolie (d) durch Belichten verändert wird, bildmäßig durch die Deckfolie (d) belichtet und durch Abziehen der Deckfolie (d) von dem Schichtträger (a) entwickelt, dadurch gekennzeichnet, daß man ein Material mit einer hydrophilen Schicht (b) einsetzt, die ein vernetzbares organisches Polymeres enthält und das Polymere vor oder nach dem Belichten vernetzt.

9. Verfahren nach Anspruch 8, dadurch gekennzeichnet, daß man das Polymere durch Erwärmen vernetzt.

10. Verfahren nach Anspruch 9, dadurch gekennzeichnet, daß man das Polymere nach dem Entwickeln durch Erwärmen auf eine Temperatur im Bereich von 180 - 240 °C vernetzt.

11. Verfahren nach Anspruch 8, dadurch gekennzeichnet, daß man das Polymere vor dem Aufbringen der Schicht (c) durch Erwärmen auf eine Temperatur im Bereich von 60 - 120 °C vernetzt.

## Claims

1. Photosensitive material for the production of planographic printing plates which contains as essential constituents
a) a layer support suitable for planographic printing plates,
b) a hydrophilic layer of an organic polymer,
c) a photopolymerisable layer and
d) a transparent cover film,
wherein the adhesion of the photopolymerisable layer (c) to the hydrophilic layer (b) and/or the cover film (d) is modified by exposure to light, characterised in that the hydrophilic layer (b) contains an organic polymer which is intrinsically crosslinking by functional groups contained therein, or that the layer additionally contains a crosslinking agent for the organic polymer, or is a layer produced by crosslinking of such a polymer.

2. Photosensitive material according to claim 1, characterised in that the crosslinkable organic polymer contains hydroxy, carboxyl or amino groups as crosslinkable groups.

3. Photosensitive material according to claim 1, characterised in that the crosslinking agent is a water-soluble, polyfunctional compound which only reacts with the polymer at elevated temperature.

4. Photosensitive material according to claim 1 or 3, characterised in that the hydrophilic layer furthermore contains a crosslinking catalyst.

5. Photosensitive material according to claim 1, characterised in that the hydrophilic layer (b) has a layer weight in the range from 0.001 to 1 g/m².

6. Photosensitive material according to claim 1, characterised in that the photopolymerisable layer (c) contains as essential constituents
(1) a polymeric binder,
(2) a free-radically polymerisable compound and
(3) a compound or combination of compounds which is capable of initiating the polymerisation of compound (2) under the action of actinic radiation.

7. Photosensitive material according to claim 1, characterised in that the photopolymerisable layer (c) has a layer weight in the range from 0.1 to 10 g/m².

8. Process for the production of a planographic printing member, in which a photosensitive material containing as essential constituents
a) a layer support suitable for planographic printing plates,
b) a hydrophilic layer of an organic polymer,
c) a photopolymerisable layer and
d) a transparent cover film,
wherein the adhesion of the photopolymerisable layer (c) to the hydrophilic layer (b) and/or the cover film (d) is modified by exposure to light, is exposed with an image through the cover film (d) and is developed by peeling the cover film (d) from the layer support (a), characterised in that a material having a hydrophilic layer (b) is used, which layer contains a crosslinkable organic polymer and the polymer crosslinks before or after the exposure to light.

9. Process according to claim 8, characterised in that the polymer is crosslinked by heating.

10. Process according to claim 9, characterised in that the polymer is crosslinked after development by heating to a temperature in the range from 180-240°C.

11. Process according to claim 8, characterised in that the polymer is crosslinked before application of layer (c) by heating to a temperature in the range from 60-120°C.

## Revendications

1. Matériau photosensible pour la fabrication de plaques d'impression qui contient comme constituants principaux
a) un support de couche convenant pour des plaques d'impression,
b) une couche hydrophile d'un polymère organique,
c) une couche photopolymérisable et
d) une feuille protectrice transparente,
l'adhésion de la couche photopolymérisable (c) à la couche hydrophile (b) et/ou la feuille protectrice (d) étant modifiée par exposition, caractérisé en ce que la couche hydrophile (b) contient un polymère organique, qui est auto-réticulé par des groupes fonctionnels contenus dans celui-ci, ou en ce qu'elle contient en outre un agent réticulant pour le polymère organique, ou est une couche formée par réticulation d'un tel polymère.

2. Matériau photosensible selon la revendication 1, caractérisé en ce que le polymère organique réticulable contient comme groupes réticulables des groupes hydroxyle, carboxyle ou amino.

3. Matériau photosensible selon la revendication 1, caractérisé en ce que l'agent réticulant est un composé polyfonctionnel soluble dans l'eau, qui réagit seulement avec les polymères à température élevée.

4. Matériau photosensible selon la revendication 1 ou 3, caractérisé en ce que la couche hydrophile contient en outre un catalyseur de réticulation.

5. Matériau photosensible selon la revendication 1, caractérisé en ce que la couche hydrophile (b) a un poids de couche dans la plage de 0,001 à 1 g/m².

6. Matériau photosensible selon la revendication 1, caractérisé en ce que la couche photopolymérisable (c) contient comme constituants principaux
(1) un liant polymère,
(2) un composé polymérisable radicalairement et
(3) un composé ou une combinaison de composés qui par action d'un rayonnement actinique peut déclencher la polymérisation du composé (2).

7. Matériau photosensible selon la revendication 1, caractérisé en ce que la couche photopolymérisable (c) a un poids de couche dans la plage de 0,1 à 10g/m².

8. Procédé de préparation d'une forme d'impression plane, selon lequel un matériau photosensible qui d'impression qui contient comme constituants principaux
a) un support de couche convenant pour des plaques d'impression,
b) une couche hydrophile d'un polymère organique,
c) une couche photopolymérisable et
d) une feuille protectrice transparente,
l'adhérence de la couche photopolymérisable (c) à la couche hydrophile (b) et/ou la feuille protectrice (d) étant modifiée par exposition, est exposé selon un motif à travers la couche protectrice (d) et développé par pelage de la couche protectrice (d) du support de couche a), caractérisé en ce qu'on utilise un matériau avec une couche hydrophile (b) qui contient un polymère organique réticulable et que le polymère est réticulé avant ou après l'exposition.

9. Procédé selon la revendication 8, caractérisé en ce qu'on réticule le polymère par chauffage.

10. Procédé selon la revendication 9, caractérisé en ce qu'on réticule le polymère après le développement par la chaleur à une température dans la plage de 180 à 240 °C.

11. Procédé selon la revendication 8, caractérisé en ce qu'on réticule le polymère avant le dépôt de la couche (c) par chauffage à une température dans la plage de 60 à 120 °C.
